(19) Europäisches Patentamt / European Patent Office / Office européen des brevets

(11) **EP 2 071 345 A1**

(12) **DEMANDE DE BREVET EUROPEEN**

(43) Date de publication:
**17.06.2009 Bulletin 2009/25**

(51) Int Cl.:
***G01R 31/36*** (2006.01)

(21) Numéro de dépôt: **08171112.9**

(22) Date de dépôt: **09.12.2008**

(84) Etats contractants désignés:
**AT BE BG CH CY CZ DE DK EE ES FI FR GB GR HR HU IE IS IT LI LT LU LV MC MT NL NO PL PT RO SE SI SK TR**
Etats d'extension désignés:
**AL BA MK RS**

(30) Priorité: **12.12.2007 FR 0759784**

(71) Demandeurs:
• **Peugeot Citroën Automobiles SA**
  **78140 Vélizy-Villacoublay (FR)**
• **CENTRE NATIONAL DE**
  **LA RECHERCHE SCIENTIFIQUE (CNRS)**
  **75794 Paris Cedex 16 (FR)**

(72) Inventeurs:
• **Cugnet, Mikaël, Georges, André**
  **75015, PARIS (FR)**
• **Sabatier, Jocelyn**
  **33140, VILLENAVE D'ORNON (FR)**
• **Bouygues, Isabelle Céline Aurélie**
  **78220, VIROFLAY (FR)**

(74) Mandataire: **Thinat, Michel**
  **Cabinet Weinstein**
  **56 A, rue du Faubourg Saint-Honoré**
  **75008 Paris (FR)**

(54) **Procédé d'estimation de la résistance interne d'une batterie de véhicule automobile**

(57) L'invention concerne un procédé d'estimation de la résistance interne d'une batterie de véhicule automobile, comprenant : une mesure du courant (i) lors du démarrage du véhicule automobile ; une mesure de la tension (u) lors du démarrage du véhicule automobile ; une étape d'injection (33) du courant mesuré ($i_{dem}$) en fonction du temps en entrée d'une famille de fonctions de transformation ($T_i$) de courant en tension, le résultat de cette étape injection étant une famille de courbes de tension ($u_i$) ; une étape de comparaison (35) entre la tension mesurée ($u_{dem}$) et la famille de courbes de tension ($u_i$), de manière à déterminer une ou plusieurs courbes de tension cible ; une étape de choix (36), comme valeur (R) de la résistance interne de la batterie, de la valeur (r (k)) de résistance interne correspondant à la fonction de transformation ayant donné la courbe de tension cible ou d'une fonction de moyenne des valeurs de résistance interne correspondant aux fonctions de transformation ayant donné les courbes de tension cible.

Figure 1

EP 2 071 345 A1

Printed by Jouve, 75001 PARIS (FR)

**Description**

L'invention concerne le domaine des procédés d'estimation de la résistance interne d'une batterie de véhicule automobile. La résistance interne de la batterie du véhicule automobile est une grandeur qui permet d'estimer la plus petite valeur de tension lors du prochain démarrage du véhicule automobile. La plus petite valeur de tension lors du prochain démarrage du véhicule automobile est une grandeur qui permet d'estimer la performance en puissance de la batterie du véhicule automobile lors du démarrage du véhicule automobile. A partir de cette performance en puissance de la batterie du véhicule automobile lors du démarrage du véhicule automobile, il est possible d'évaluer la capacité de la batterie à permettre, en fournissant la puissance nécessaire au démarrage du véhicule automobile, un démarrage effectif du véhicule automobile à la prochaine tentative de démarrage du véhicule automobile par le conducteur. Toutes ces estimations doivent pouvoir être réalisées en ligne et non pas hors ligne, c'est-à-dire directement sur la batterie montée sur le véhicule automobile et en état de fonctionnement normal et non pas en dehors du véhicule automobile sur une batterie ayant été préalablement démontée du véhicule automobile et placée dans des conditions de mesure de type laboratoire.

Selon un premier art antérieur, il est connu un procédé d'estimation de la résistance interne de la batterie du véhicule automobile par spectroscopie d'impédance de la batterie. L'instrumentation nécessaire implique de réaliser les mesures du spectre d'impédance de la batterie à faible valeur de courant. Or, les conditions de démarrage du véhicule automobile correspondent à de très fortes valeurs de courant même si celles-ci n'existent que pendant un temps relativement faible. Le caractère non linéaire des phénomènes qui s'accentue de manière importante lors d'une forte augmentation de la valeur du courant empêche une extrapolation fiable à partir des mesures de spectroscopie d'impédance de la batterie réalisées à faible courant.

Selon un deuxième art antérieur, il est connu un procédé d'estimation de la résistance interne de la batterie du véhicule automobile par mesure d'impédance de la batterie et par extrapolation de la résistance interne de la batterie de manière immédiate à partir de l'impédance mesurée. Ce procédé, rigoureusement valable pour des conditions de fonctionnement en courant continu, n'est déjà qu'une approximation plus ou moins pertinente pour des conditions de courant variable mais périodique, et devient tout à fait non fiable pour des conditions de courant transitoire plutôt aléatoire qui sont celles d'un démarrage de véhicule automobile.

Pour l'invention, le problème principal à résoudre devient donc d'être capable de fournir une estimation fiable de la valeur de la résistance interne de la batterie du véhicule automobile. En effet, une estimation fiable de la résistance interne de la batterie du véhicule automobile permet une estimation fiable de la plus petite valeur de tension lors du prochain démarrage du véhicule automobile laquelle permet alors une estimation fiable de la performance en puissance de la batterie du véhicule automobile lors du démarrage du véhicule automobile. A partir de cette estimation fiable de la performance en puissance de la batterie de véhicule automobile lors du démarrage du véhicule automobile, il est possible d'évaluer de manière fiable la capacité de la batterie à permettre un démarrage effectif du véhicule automobile à la prochaine tentative de démarrage du véhicule automobile par le conducteur par sa capacité à fournir la puissance nécessaire au démarrage du véhicule automobile.

Selon l'invention, il est prévu un procédé d'estimation de la résistance interne d'une batterie de véhicule automobile, comprenant : une mesure du courant traversant la batterie en fonction du temps lors du démarrage du véhicule automobile ; une mesure de la tension aux bornes de la batterie en fonction du temps lors du démarrage du véhicule automobile ; une étape d'injection du courant mesuré en fonction du temps en entrée d'une famille de fonctions de transformation de courant en tension, les fonctions de transformation correspondant respectivement à des valeurs distinctes entre elles de la résistance interne de la batterie, le résultat de cette étape injection étant une famille de courbes de tension en fonction du temps qui sont représentatives de la tension en fonction du temps aux bornes de la batterie qui serait obtenue lors du démarrage du véhicule pour lesdites valeurs de résistance interne de la batterie ; une étape de comparaison entre d'une part la tension mesurée en fonction du temps et d'autre part la famille de courbes de tension en fonction du temps, de manière à déterminer une ou plusieurs courbes de tension cible qui sont la ou les courbes de tension de la famille les plus proches de la tension mesurée ; une étape de choix, comme valeur de la résistance interne de la batterie, de la valeur de résistance interne correspondant à la fonction de transformation ayant donné la courbe de tension cible ou d'une fonction de moyenne des valeurs de résistance interne correspondant aux fonctions de transformation ayant donné les courbes de tension cible.

Lors de la mesure du courant traversant la batterie en fonction du temps lors du démarrage du véhicule automobile, on relève l'évolution du courant en fonction du temps pendant la phase de démarrage du véhicule automobile, de préférence depuis le signal de démarrage suivie de la baisse de courant associée jusqu'à la remontée du courant à des valeurs positives témoignant de l'entrée en action de l'alternateur.

Lors de la mesure de la tension aux bornes de la batterie en fonction du temps lors du démarrage du véhicule automobile, on relève l'évolution de la tension en fonction du temps pendant la phase de démarrage du véhicule automobile, de préférence depuis le signal de démarrage suivie de la baisse de courant associée jusqu'à la remontée du courant à des valeurs positives témoignant de l'entrée en action de l'alternateur.

Lors de l'étape d'injection du courant mesuré en fonction du temps en entrée d'une famille de fonctions de transformation de courant en tension, on obtient une famille de courbes de tension en fonction du temps.

Si l'on considère une courbe de tension en fonction du temps obtenue, on constate que celle-ci correspond à une valeur supposée de la résistance interne de la batterie, c'est-à-dire que la fonction de transformation correspondante, utilisée pour obtenir ladite courbe de tension donnée, a été conçue pour transformer le courant mesuré en la courbe de tension du temps donnée, à la condition que la valeur effective de la résistance interne de la batterie soit bien de fait la valeur supposée de la résistance interne de la batterie.

Dans un mode de réalisation préférentiel, le procédé d'estimation de la résistance interne de la batterie comprend une étape de comparaison entre d'une part la tension mesurée en fonction du temps et d'autre part la famille de courbes de tension en fonction du temps, de manière à déterminer une courbe de tension cible qui est la courbe de tension de la famille la plus proche de la tension mesurée et une étape de choix, comme valeur de la résistance interne de la batterie, de la valeur de la résistance interne correspondant à la fonction de transformation ayant donné la courbe de tension cible.

Dans ce mode de réalisation préférentiel, si la tension mesurée se confond avec l'une des courbes de tension en fonction du temps, que l'on appellera alors courbe de tension cible, cela signifiera que la valeur effective de la résistance interne de la batterie correspond effectivement à la valeur supposée de la résistance interne de la batterie correspondant à la courbe de tension cible. Si la tension mesurée ne se confond pas avec l'une des courbes de tension en fonction du temps, mais est par contre très proche de l'une de ces courbes de tension en fonction du temps, c'est-à-dire plus proche de l'une d'entre elles que des autres, on pourra de même appeler courbe de tension cible cette courbe de tension plus proche que les autres de la tension mesurée. C'est ce qui peut être fait dans l'étape de comparaison entre d'une part la tension mesurée en fonction du temps et d'autre part la famille de courbes de tension en fonction du temps.

Dans un mode de réalisation optionnel alternatif, si la tension mesurée se confond avec l'une des courbes de tension en fonction du temps, et reste en même temps proche d'une ou de plusieurs autres courbes de tension en fonction du temps, toutes ces courbes de tension confondue ou proche(s) seront appelées alors courbes de tension cibles. Si la tension mesurée ne se confond pas avec l'une des courbes de tension en fonction du temps, mais est par contre proche ou très proche de l'une de ces courbes de tension en fonction du temps ou de plusieurs de ces courbes de tension en fonction du temps, c'est-à-dire plus proche de l'une ou de certaines d'entre elles que des autres, on pourra de même appeler courbe(s) de tension cible(s) cette courbe de tension plus proche que les autres de la tension mesurée ou ces courbes de tension plus proches que les autres de la tension mesurée. C'est ce qui peut également être fait dans l'étape de comparaison entre d'une part la tension mesurée en fonction du temps et d'autre part la famille de courbes de tension en fonction du temps.

Dans le mode de réalisation préférentiel, on pourra ensuite en déduire que la valeur effective de la résistance interne de la batterie est relativement proche de la valeur supposée de la résistance interne correspondant à la courbe de tension cible, et on pourra même aller jusqu'à considérer que la valeur effective de la résistance interne de la batterie est égale à la valeur supposée de la résistance interne de la batterie correspondant à la courbe de tension cible. C'est ce qui peut être fait dans l'étape de choix de la valeur de la résistance interne de la batterie.

Dans le mode de réalisation optionnel alternatif, on pourra ensuite en déduire que la valeur effective de la résistance interne de la batterie correspond à une fonction de type moyenne réalisée à partir des valeurs supposées de la résistance interne de la batterie correspondant aux courbes de tension cibles. Cette fonction de type moyenne sera de préférence une moyenne pondérée, les facteurs de pondération reflétant la proximité respective entre d'une part la tension mesurée et d'autre part les courbes de tension cibles. Dans certains cas, la moyenne pondérée peut se trouver être réalisée à partir d'une seule résistance interne si une seule courbe de tension cible a été obtenue, elle rejoint alors, pour ces cas là, la méthode simple employée pour le mode de réalisation préférentiel. C'est ce qui peut également être fait dans l'étape de choix de la valeur de la résistance interne de la batterie.

Il est encore possible de retenir plusieurs courbes de tension cible dans une première étape et de ne conserver pour la détermination de la résistance interne de la batterie que la courbe de tension cible la plus proche de la tension mesurée. Dans ce cas particulier, on réalise à la fois les deux modes de réalisation, préférentiel et optionnel alternatif. En effet, d'une part, on peut considérer que retenir plusieurs courbes de tension cibles pour n'en conserver ensuite qu'une seule est équivalent à n'en retenir qu'une seule, les autres n'ayant aucune influence pratique sur la détermination de la résistance interne de la batterie. En effet, d'autre part, on peut considérer que retenir plusieurs courbes de tension cibles pour n'en conserver ensuite qu'une seule est équivalent à faire une moyenne pondérée des courbes de tension cibles retenues, soit en mettant une pondération infinie à la courbe de tension cible la plus proche et à mettre des pondérations finies aux autres, soit en mettant une pondération nulle à toutes les courbes de tension cibles sauf à la courbe de tension cible la plus proche à laquelle on met une pondération finie, ce qui entraîne comme conséquence que seule la courbe de tension cible la plus proche a une influence pratique sur la détermination de la résistance interne de la batterie.

Il est plus facile de manipuler les transformations de courant en tension dans le domaine fréquentiel que dans le domaine temporel. La transformation de courant en tension est donc préférentiellement réalisée dans le domaine fréquentiel plutôt que temporel. Pour cela, avant la transformation proprement dite, pour le courant on passe du domaine temporel au domaine fréquentiel, tandis qu'après la transformation proprement dite, pour la tension on repasse du domaine fréquentiel au domaine temporel. De préférence, la fonction de transformation effectue successivement : une première opération de transformation du courant mesuré en fonction du temps en un courant mesuré en fonction de la fréquence ; une deuxième opération de transformation du courant mesuré en fonction de la fréquence en une courbe de tension en fonction de la fréquence au moyen d'un produit du courant mesuré en fonction de la fréquence par la fonction de transfert de la fonction de transformation ; une troisième opération de transformation de la courbe de tension en fonction de la fréquence en une courbe de tension en fonction du temps.

Différentes fonctions de transformation peuvent être envisagées. Ces fonctions de transformation risquent d'être complexes et volumineuses. Une forme particulière de fonction de transformation plus simple et plus ramassée est préférée. Cette forme particulière est basée sur une utilisation plus ou moins large de puissance non entière dans la formulation. En effet, le fait d'utiliser une puissance non entière, à priori plus complexe, permet en fait de beaucoup simplifier la fonction de transformation en diminuant à la fois le nombre de paramètres et le nombre de termes qu'elle comprend, grâce au degré de liberté très important que la puissance non entière offre et qui dans le cas de l'invention se révèle en fait très utile et très fructueux. Une utilisation plus large de cette puissance non entière se révèle plus fructueuse et est donc préférée pour ce motif, mais une utilisation plus parcimonieuse, quoique moins intéressante, présente tout de même un avantage appréciable. Dans une première réalisation préférentielle, pour chacune des fonctions de transformation $T_i$ de la famille, la deuxième opération est réalisée à l'aide d'une fonction $F_i$ ayant la forme suivante : $F_i = K_{1i} (G_i (f))^{x_i}$ ; avec $K_{1i}$ constante, $G_i$ une autre fonction, f la fréquence, $x_i$ un nombre réel ou complexe, $x_i$ étant un nombre non entier pour au moins une fonction de transformation. La fonction $F_i$ est la fonction de transfert de la fonction de transformation. Dans une deuxième réalisation plus préférentielle, pour chacune des fonctions de transformation $T_i$ de la famille, la deuxième opération est réalisée à l'aide d'une fonction $F_i$ ayant la forme suivante : $F_i = K_{1i} (G_i (f))^{x_i}$ ; avec $K_{1i}$ constante, $G_i$ une autre fonction, f la fréquence, $x_i$ un nombre réel ou complexe, $x_i$ étant un nombre non entier pour plusieurs fonctions de transformation. Dans une troisième réalisation encore plus préférentielle, pour chacune des fonctions de transformation $T_i$ de la famille, la deuxième opération est réalisée à l'aide d'une fonction $F_i$ ayant la forme suivante : $F_i = K_{1i} (G_i (f))^{x_i}$ ; avec $K_{1i}$ constante, $G_i$ une autre fonction, f la fréquence, $x_i$ un nombre réel ou complexe, $x_i$ étant un nombre non entier pour toutes les fonctions de transformation.

Le fait d'accepter d'utiliser des puissances non entières est très puissant car il permet d'obtenir une fonction de transformation, qui présente, en fonction de la fréquence, un nombre réduit de termes qui sont de plus des termes simples. Une forme optimisée préférentielle de la fonction de transformation peut ainsi être déterminée. De préférence, pour chacune des fonctions de transformation $T_i$ de la famille, la fonction $G_i$ a la forme suivant $G_i = (K_{2i} + jw)/(K_{3i} + jw)$ ; avec $K_{2i}$ et $K_{3i}$ constantes, $w = 2 \pi f$, f la fréquence, j le nombre complexe tel que $j^2 = -1$.

Une alternative optionnelle à la transformation de courant en tension dans le domaine fréquentiel est la transformation de courant en tension dans le domaine temporel. Dans ce cas, la fonction de transformation effectue une unique opération de transformation du courant mesuré en fonction du temps en une courbe de tension en fonction du temps au moyen d'un produit de convolution du courant mesuré en fonction du temps par la réponse impulsionnelle de la fonction de transformation.

Pour l'étape de comparaison entre d'une part la tension mesurée et d'autre part les courbes de tension, différentes méthodes de comparaison peuvent être envisagées. Parmi ces différentes méthodes, la méthode basée sur la minimisation de l'énergie de la différence entre les éléments comparés est préférée, car elle donne dans le cadre du procédé d'estimation de la résistance interne de la batterie selon l'invention, de bons résultats. De préférence, pour une ou plusieurs courbes de tension, une première opération de calcul d'une grandeur représentative de l'énergie en fonction du temps de la différence entre la tension mesurée et la courbe de tension ; sur une plage temporelle donnée, une opération de ratio entre d'une part la grandeur représentative de l'énergie en fonction du temps et d'autre part un seuil variable en fonction du temps ; soit une opération de validation de la courbe de tension si le majorant des ratios sur la plage temporelle donnée ne dépasse pas un seuil prédéterminé et identique pour toutes les courbes de tension, soit une opération d'invalidation de la courbe de tension si le majorant des ratios sur la plage temporelle donnée dépasse ledit seuil prédéterminé.

Dans le cas du mode de réalisation préférentiel, le résultat de l'étape de comparaison ne donnera au plus qu'une seule courbe de tension cible. La détermination de la présence ou de l'absence de cette courbe de tension cible va dépendre du nombre de courbes de tension qui auront été préalablement validées pendant l'étape de comparaison, à savoir une seule courbe de tension validée, ou bien plusieurs courbes de tension validées, ou bien encore aucune courbe de tension validée. De préférence, si une seule courbe de tension a été validée, la courbe de tension cible est ladite courbe de tension validée ; si plusieurs courbes de tension ont été validées, la courbe de tension cible est la courbe de tension validée présentant le plus petit majorant ; si aucune courbe de tension n'est validée, soit le majorant de la courbe de tension correspondant à la plus petite valeur de résistance interne de la batterie est inférieur au majorant de la courbe de tension correspondant à la plus grande valeur de résistance interne de la batterie et une information de court-circuit de la batterie est émise sur le réseau du véhicule automobile, soit le majorant de la courbe de tension correspondant à la plus petite valeur de résistance interne de la batterie est supérieur au majorant de la courbe de tension correspondant à la plus grande valeur de résistance interne de la batterie et une information de décharge excessive ou de vieillissement excessif de la batterie est émise sur le réseau du véhicule automobile.

Dans le cas d'un mode de réalisation optionnel, le résultat de l'étape de comparaison pourra donner aucune, une ou plusieurs courbes de tension cibles. La détermination de la présence ou de l'absence de cette courbe de tension cible ou de ces courbes de tension cibles va dépendre du nombre de courbes de tension qui auront été préalablement validées pendant l'étape de comparaison, à savoir une seule courbe de tension validée, ou bien plusieurs courbes de tension validées, ou bien encore aucune courbe de tension validée. De préférence, si une seule courbe de tension a été validée, la courbe de tension cible est ladite courbe de tension validée ; si plusieurs courbes de tension ont été validées, les courbes de tension cibles sont les courbes de tension validées, la valeur de la résistance interne de la batterie étant obtenue à l'aide de la moyenne arithmétique des valeurs de résistance interne correspondant aux fonctions de transformation ayant donné les courbes de tension cibles respectivement pondérées par les valeurs des majorants correspondant aux dites courbes de tension cibles ; si aucune courbe de tension n'est validée, soit le majorant de la courbe de tension correspondant à la plus petite valeur de résistance interne de la batterie est inférieur au majorant de la courbe de tension correspondant à la plus grande valeur de résistance interne de la batterie et une information de court-circuit de la batterie est émise sur le réseau du véhicule automobile, soit le majorant de la courbe de tension correspondant à la plus petite valeur de résistance interne de la batterie est supérieur au majorant de la courbe de tension correspondant à la plus grande valeur de résistance interne de la batterie et une information de décharge excessive ou de vieillissement excessif de la batterie est émise sur le réseau du véhicule automobile.

Pour obtenir un meilleur compromis entre d'une part pertinence et précision des calculs effectués et d'autre part simplicité et rapidité des calculs à effectuer, certaines approximations vont avantageusement être réalisées au cours des calculs. On peut toutes les réaliser, ce qui est optimal, ou n'en réaliser que certaines, ce qui est déjà avantageux. De préférence, la grandeur représentative de l'énergie en fonction du temps est un majorant de l'énergie en fonction du temps. De préférence, le seuil prédéterminé et identique pour toutes les courbes de tension est une grandeur représentative de l'énergie d'une fonction d'incertitude en fonction du temps.

Pour les fonctions de transformation, correspondant aux différentes valeurs de résistance interne de batterie, il est avantageux du point de vue de la simplicité d'en prendre le moins possible. Par contre, du point de vue de l'exhaustivité, il est avantageux d'en prendre le plus possible. L'invention s'est aperçu de deux simplifications possibles, utilisables séparément ou préférentiellement en combinaison. La première simplification consiste à ne pas explorer de valeurs de résistances internes en dessous d'un certain seuil dépendant de la technologie de batterie considérée, car dans ce cas, on est pratiquement certain que la batterie souffre de toutes façons d'un court-circuit, et que dans ce cas une détermination précise de la valeur de la résistance interne de la batterie ne présente que peu d'intérêt pratique. La deuxième simplification consiste à ne pas explorer de valeurs de résistances internes au dessus d'un certain seuil dépendant de la technologie de batterie considérée, car dans ce cas, on est pratiquement certain que la batterie est suffisamment usagée pour présenter un risque important et probable de ne pas permettre un démarrage ultérieur du véhicule automobile ; dans ce cas, une détermination précise de la valeur de la résistance interne de la batterie, dans le but de déterminer si le risque de non démarrage est important, très important ou extrêmement important, ne présente que peu d'intérêt pratique dans la mesure où il est alors grand temps d'envisager le rechargement ou le remplacement de la batterie. De préférence, les valeurs de résistance interne de batterie correspondant aux fonctions de transformation sont toutes inférieures à une valeur maximum de résistance interne de batterie au-delà de laquelle le démarrage du véhicule n'est plus certain. De préférence, les valeurs de résistance interne de batterie correspondant aux fonctions de transformation sont toutes supérieures à une valeur minimum de résistance interne de batterie en dessous de laquelle le démarrage du véhicule n'est plus possible. Avantageusement, pour les batteries de technologie plomb - acide liquide, une fourchette numérique optimale a été déterminée. Avantageusement, les valeurs de résistance interne de batterie correspondant aux fonctions de transformation sont comprises entre 4 milli ohms et 9 milli ohms.

Tout en ne réalisant pas une mesure du spectre de l'impédance de la batterie, mesure qui ne peut être obtenue directement qu'à faible courant comme dans le premier art antérieur et qui ne peut être extrapolée de manière fiable à fort courant, les différentes fonctions de transformation correspondent avantageusement respectivement à différents spectres de l'impédance de la batterie obtenus respectivement pour différents états de charge et différents états de santé de batterie. Ces fonctions de transformation sont donc aussi riches en contenu d'information que des spectres d'impédance du premier art antérieur tout en étant sous une forme compatible avec une utilisation fiable dans les conditions du démarrage du moteur d'un véhicule automobile, c'est-à-dire sous une forme compatible avec les conditions de fort courant, et non pas sous forme uniquement compatible avec les conditions de faible courant comme les mesures de spectre d'impédance rencontrées dans le premier art antérieur.

De préférence, les différentes fonctions de transformation sont obtenues de manière empirique par séries de mesure sur plusieurs batteries de même modèle. C'est ainsi que peuvent être obtenues les fonctions de transformation les plus représentatives du comportement d'une batterie du modèle considéré. Des approximations peuvent être obtenues par calcul mais celles-ci sont moins représentatives du comportement d'une batterie réelle.

De préférence, le procédé d'estimation de la résistance interne de la batterie selon l'invention ne nécessite pas d'autre mesure que les seuls paramètres mesurés que sont d'une part le courant traversant la batterie et d'autre part la tension aux bornes de la batterie. Ce nombre minimal de paramètres mesurés en fait un procédé relativement simple par rapport à sa grande fiabilité et à sa bonne précision dans la détermination de la valeur de la résistance interne de la batterie.

Le procédé d'estimation de la résistance interne de la batterie est utilisé pour déterminer avec une grande fiabilité et une bonne précision la valeur de la résistance interne de la batterie. Une fois déterminée, cette valeur de la résistance interne de la batterie, ou le cas échéant l'impossibilité constatée de déterminer la valeur de la résistance interne de la batterie, est utilisée par un procédé d'estimation de la performance en puissance d'une batterie de véhicule automobile lors du démarrage du véhicule automobile lequel procédé d'estimation permettra de déterminer avec une bonne fiabilité la présence ou non d'un risque important pour la batterie de ne pas permettre le démarrage du véhicule automobile lors du prochain essai de démarrage du véhicule automobile par le conducteur.

Selon l'invention, il est également prévu un procédé d'estimation de la performance en puissance d'une batterie de véhicule automobile lors du démarrage du véhicule automobile comprenant successivement : un procédé d'estimation de la résistance interne de batterie selon l'une quelconque des revendications précédentes ; une phase d'estimation de la plus petite valeur de tension lors du prochain démarrage de véhicule automobile à partir de ladite résistance interne estimée ; si aucune résistance interne n'a pu être déterminée par le procédé d'estimation de la résistance interne, alors une information soit de court-circuit de la batterie soit de décharge excessive ou de vieillissement excessif de la batterie est émise sur le réseau du véhicule automobile ; si une résistance interne a pu être déterminée par le procédé d'estimation de la résistance interne et si ladite plus petite valeur de tension estimée est inférieure à un seuil donné, alors une information de décharge excessive ou de vieillissement excessif de la batterie est émise sur le réseau du véhicule automobile. Le réseau du véhicule automobile est de préférence un réseau CAN.

Dans le cas où la valeur de la résistance interne de la batterie déterminée permet un démarrage du véhicule automobile lors du prochain essai du démarrage, il est toutefois utile pour le réseau du véhicule automobile de connaître la valeur précise de cette résistance interne, notamment pour conserver un historique au cours du temps des valeurs de résistance interne de la batterie, de manière à pouvoir écarter, sans conséquence nuisible, un point aberrant de la valeur de la résistance interne de la batterie qui aurait été obtenue par une mesure défectueuse. Inversement, si l'historique confirme l'évolution de dégradation de la valeur de la résistance interne de la batterie, alors le réseau du véhicule automobile peut en tirer la conséquence qui s'impose, à savoir le plus souvent changer une batterie devenue trop usagée. Dans le procédé d'estimation de la performance en puissance d'une batterie de véhicule automobile lors du démarrage du véhicule automobile selon l'invention, de préférence, si une résistance interne a pu être déterminée par le procédé d'estimation de la résistance interne et si ladite plus petite valeur de tension estimée est supérieure audit seuil donné, alors la valeur de ladite plus petite valeur de tension estimée est émise sur le réseau du véhicule automobile.

De préférence, le procédé d'estimation de la performance en puissance d'une batterie de véhicule automobile lors du démarrage du véhicule automobile selon l'invention ne nécessite pas d'autre mesure que les seuls paramètres mesurés que sont le courant traversant la batterie, la tension aux bornes de la batterie, et la température au niveau de la batterie. Ce nombre minimal de paramètres mesurés en fait un procédé relativement simple en considération de sa grande fiabilité dans la détermination de la capacité de la batterie à permettre le démarrage du véhicule automobile lors du prochain essai de démarrage du véhicule automobile.

L'invention va maintenant être décrite plus en détail à l'aide des figures ci-après, données à titre d'exemples illustratifs et non limitatifs, où :

- la figure 1 représente schématiquement un diagramme montrant les différentes étapes d'un exemple de procédé d'estimation de la performance en puissance d'une batterie de véhicule automobile lors du démarrage du véhicule automobile utilisant un procédé d'estimation de la résistance interne de batterie selon l'invention, ainsi que d'autres procédés permettant d'obtenir l'état de charge, l'état de santé et l'état de fonctionnement de la batterie ;
- la figure 2 représente schématiquement un exemple de courbe montrant la relation pouvant exister entre d'une part la capacité déchargée d'une batterie neuve et d'autre part la tension à vide de cette batterie ;
- la figure 3 représente schématiquement des exemples de diagramme de Nyquist de l'impédance d'une batterie usagée pour différents états de charge de la batterie ;
- la figure 4 représente schématiquement des exemples de diagramme de Nyquist de différents modèles nominaux de batterie associés à leurs modèles d'incertitude respectifs ;
- la figure 5 représente schématiquement sous forme simplifiée un exemple d'action d'une famille de fonctions de transformation de courant en tension d'un procédé d'estimation de la résistance interne d'une batterie selon l'invention ;
- la figure 6 représente schématiquement un diagramme montrant les différentes étapes d'un exemple de procédé d'estimation de la résistance interne de batterie selon l'invention ;

- la figure 7A représente schématiquement un exemple de l'évolution, en fonction du temps, du courant traversant la batterie d'un véhicule automobile, lors du démarrage du véhicule automobile, ainsi que les différentes étapes du traitement de ce signal ;
- la figure 7B représente schématiquement un exemple de l'évolution, en fonction du temps, de la tension aux bornes de la batterie d'un véhicule automobile, lors du démarrage du véhicule automobile, ainsi que les différentes étapes du traitement de ce signal ;
- la figure 8 représente schématiquement un exemple d'évolutions, en fonction du temps, pour une famille de fonctions de transformation de courant en tension, du majorant du module de la pondération d'incertitude utilisé dans un procédé d'estimation de la résistance interne de la batterie selon l'invention.

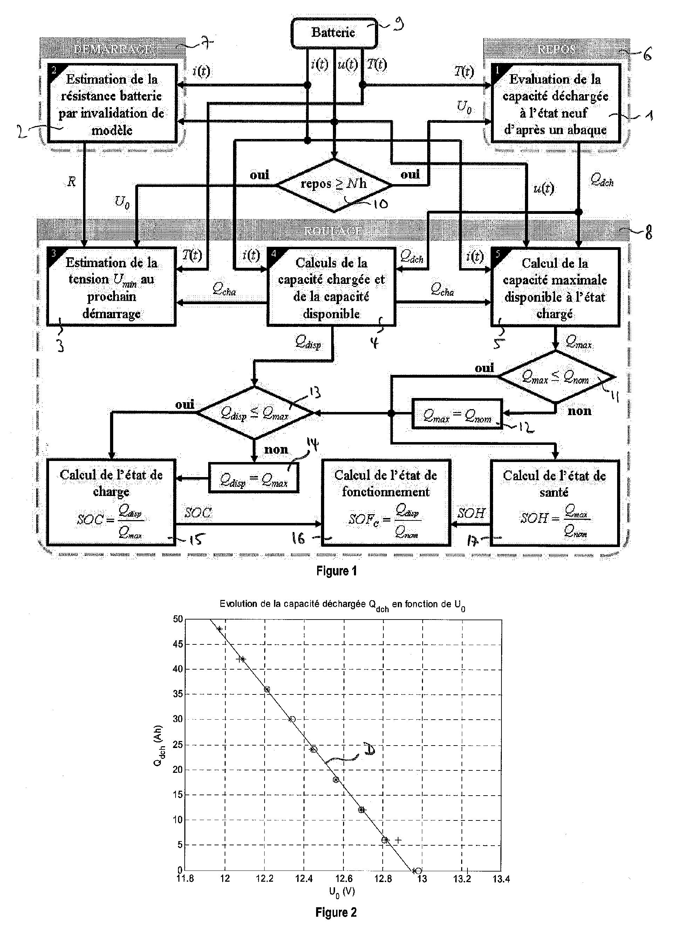

La figure 1 représente schématiquement un diagramme montrant les différentes étapes d'un exemple de procédé d'estimation de la performance en puissance d'une batterie de véhicule automobile lors du démarrage du véhicule automobile utilisant un procédé d'estimation de la résistance interne de batterie selon l'invention, ainsi que d'autres procédés permettant d'obtenir l'état de charge, l'état de santé et l'état de fonctionnement de la batterie. Sur la figure 1, la convention récepteur est adoptée, ce qui présuppose qu'un courant positif charge la batterie tandis qu'un courant négatif décharge la batterie.

Différentes grandeurs et paramètres vont être utilisés pour décrire les différentes étapes et les différents calculs réalisés d'une part dans le procédé d'estimation de la résistance interne de la batterie selon l'invention et d'autre part dans le procédé d'estimation de la performance en puissance d'une batterie de véhicule automobile lors du démarrage du véhicule automobile selon l'invention, ainsi que dans d'autres procédés, d'estimation de l'état de charge de la batterie, d'estimation de l'état de fonctionnement de la batterie, d'estimation de l'état de santé de la batterie, qui peuvent également être utilisés.

Toutes ces grandeurs et paramètres sont résumés dans le tableau de la nomenclature des grandeurs et paramètres utilisés, présenté ci-après.

Les unités utilisées dans le tableau de la nomenclature sont les suivantes :

Sh = Siemens heure
V = Volt
Ah = Ampère heure
A = Ampère
$\Omega$ = Ohm
°C = degré Celsius
s = seconde
- = sans unité

Tableau de la nomenclature des grandeurs et des paramètres utilisés

| Symbole | Nom des variables et des paramètres utilisés | Unité |
|---------|----------------------------------------------|-------|
| $a_{dch}$ | Coefficient directeur de la fonction liant $Q_{dch}$ à $U_0$ | Sh |
| $b$ | Signal de bruit contenu dans les signaux de démarrage | V |
| $b_{dch}$ | Ordonnée à l'origine de la fonction liant $Q_{dch}$ à $U_0$ | Ah |
| $b_{max}$ | Valeur maximale de la composante variable du bruit | V |
| $I_{min}$ | Courant minimal lors du pic de démarrage | A |
| $I_{offset}$ | Courant d'offset servant au recalage à zéro du signal $i_{dem}$ | A |
| $i$ | Courant | A |
| $i_{min}$ | Courant minimal en fin de charge par l'alternateur | A |
| $i_{seuil}$ | Courant de seuil caractéristique du début du démarrage | A |
| $i_{dem}$ | Courant de démarrage filtré et recalé à zéro | A |
| $k$ | Indice du modèle satisfaisant la condition de non invalidation | - |
| $n$ | Nombre de modèles nominaux mis en oeuvre | - |
| $Q_{cha}$ | Capacité chargée | Ah |

(suite)

| Symbole | Nom des variables et des paramètres utilisés | Unité |
|---|---|---|
| $Q_{dch}$ | Capacité déchargée | Ah |
| $Q_{disp}$ | Capacité disponible | Ah |
| $Q_{max}$ | Capacité maximale disponible | Ah |
| $Q_{nom}$ | Capacité nominale | Ah |
| $R$ | Résistance | Ω |
| $r$ | Fonction qui associe $R$ à l'indice du modèle nominal $k$ | Ω |
| $SOC$ | Etat de charge | - |
| $SOF_C$ | Etat de fonctionnement énergétique | - |
| $SOH$ | Etat de santé | - |
| $T$ | Température | °C |
| $t$ | Temps | s |
| $t_d$ | Début du démarrage lorsque $i < i_{seuil}$ | s |
| $t_{max}$ | Durée des signaux de démarrage $u_{dem}$ et $i_{dem}$ | s |
| $U_0$ | Tension à vide | V |
| $U_{min}$ | Tension minimale lors du pic de démarrage | V |
| $U_{offset}$ | Tension d'offset servant au recalage à zéro du signal $u_{dem}$ | V |
| $u$ | Tension | V |
| $u_i$ | Tension de sortie des modèles nominaux $P_{nom}(i)$ | V |
| $u_{seuil}$ | Tension de seuil caractéristique de la charge par l'alternateur | V |
| $u_{dem}$ | Tension de démarrage filtrée et recalée à zéro | V |
| $v$ | Perturbation en sortie de la pondération d'incertitude $\Delta$ | V |
| $w$ | Signal de bruit | V |
| $z$ | Signal en sortie du modèle d'incertitude | V |
| $\alpha$ | Facteur d'efficacité de charge | - |
| $\beta$ | Majorant du module de la pondération d'incertitude $\Delta$ | - |
| $\gamma$ | Critère d'invalidation et norme maximale du majorant $\beta$ | - |
| $\Delta$ | Pondération d'incertitude | - |
| $\tau$ | Variable temporelle utilisée dans le calcul intégral | s |

Sur la figure 1, différentes grandeurs vont être mesurées ou estimées au cours de différentes phases de fonctionnement du véhicule automobile. Les différentes phases de fonctionnement du véhicule automobile sont la phase de repos 6, la phase de démarrage 7, la phase de roulage 8.

Pendant la phase de repos 6, il est procédé à une évaluation 1 de la capacité déchargée $Q_{dch}$ à l'état neuf d'après un abaque. Cette évaluation 1 reçoit en entrée la température T de la batterie au repos ainsi que la tension à vide $U_0$ et au repos de la batterie. Cette évaluation 1 sera détaillée ultérieurement.

Pendant la phase de démarrage 7, il est procédé à une estimation 2 de la résistance interne R de la batterie, selon le procédé d'estimation de la résistance interne de la batterie selon l'invention, de préférence par invalidation de modèle. Cette estimation 2 reçoit en entrée le courant i traversant la batterie et la tension u aux bornes de la batterie. Cette estimation 2 sera détaillée ultérieurement.

Divers capteurs de courant, de tension et de température sont disposés au voisinage de la batterie 9 pour en mesurer respectivement le courant i qui la traverse, la tension u qui est à ses bornes, et sa température T, au cours du temps t. Une validation 10 de l'état de repos détermine si oui ou non la batterie est bien au repos depuis un nombre d'heures suffisant ici choisi égal à N, et donc si la tension u mesurée correspond bien à la tension à vide et au repos $U_0$. N est par exemple choisi comme valant huit.

Pendant la phase de roulage 8, il est procédé à une estimation 3 de la tension minimale $U_{min}$ lors du pic de prochain démarrage, selon le procédé d'estimation de la performance en puissance d'une batterie de véhicule automobile lors du démarrage du véhicule automobile selon l'invention. Cette estimation 3 reçoit en entrée la résistance interne R de la batterie, la tension à vide et au repos $U_0$, la température T de la batterie, ainsi que la capacité chargée $Q_{cha}$. Cette estimation 3 sera détaillée ultérieurement.

Un calcul 4 de la capacité chargée $Q_{cha}$ et de la capacité disponible $Q_{disp}$ est réalisé et sera détaillé ultérieurement. Ce calcul 4 reçoit en entrée le courant i traversant la batterie et la capacité déchargée $Q_{dch}$.

Un calcul 5 de la capacité $Q_{max}$ maximale disponible à l'état chargé de la batterie est réalisé et sera détaillé ultérieurement. Ce calcul 5 reçoit en entrée le courant i traversant la batterie, la tension u aux bornes de la batterie, la capacité déchargée $Q_{dch}$ et la capacité chargée $Q_{cha}$.

Une vérification 11 est réalisée pour s'assurer que la capacité maximale $Q_{max}$ est bien inférieure à la capacité nominale $Q_{nom}$ de la batterie laquelle capacité nominale $Q_{nom}$ est une constante pour une batterie donnée. Dans le cas marginal où la capacité maximale $Q_{max}$ obtenue par calcul serait supérieure à la capacité nominale $Q_{nom}$, ce qui serait tout de même curieux et ne pourrait provenir que d'un artefact du calcul, la capacité maximale $Q_{max}$ est limitée à la valeur de la capacité nominale $Q_{nom}$ par un plafonnement 12.

Une vérification 13 est réalisée pour vérifier que la capacité disponible $Q_{disp}$ est bien inférieure à la capacité maximale $Q_{max}$. Dans le cas marginal où la capacité disponible $Q_{disp}$ obtenue par calcul serait supérieure à la capacité maximale $Q_{max}$, ce qui serait tout de même curieux et ne pourrait provenir que d'un artefact du calcul, la capacité disponible $Q_{disp}$ est limitée à la valeur de la capacité maximale $Q_{max}$ par un plafonnement 14.

Un calcul 15 de l'état de charge SOC de la batterie est réalisé par le ratio de la capacité disponible $Q_{disp}$ et de la capacité maximale $Q_{max}$. Un calcul 17 de l'état de santé SOH de la batterie est réalisé par le ratio de la capacité maximale $Q_{max}$ et de la capacité nominale $Q_{nom}$. Un calcul 16 de l'état de fonctionnement énergétique SOFc de la batterie est réalisé par le produit de l'état de charge SOC et de l'état de santé SOH, ce qui correspond au ratio de la charge disponible $Q_{disp}$ et de la capacité nominale $Q_{nom}$.

L'évaluation 1 de la capacité déchargée $Q_{dch}$ à l'état neuf d'après un abaque va maintenant être détaillée.

L'état de charge SOC d'une batterie peut être considéré, si la batterie est neuve, comme n'étant une fonction f que de deux paramètres, à savoir la tension à vide $U_0$ de la batterie et la température T de la batterie, ce que traduit l'équation (1) :

$$SOC = f(U_0, T) \qquad (1)$$

La batterie étant neuve, on peut également relier l'état de charge SOC à la capacité nominale $Q_{nom}$ à l'aide de la capacité déchargée $Q_{dch}$ par l'équation (2) :

$$SOC = \frac{Q_{nom} - Q_{dch}}{Q_{nom}} \qquad (2)$$

En éliminant l'état de charge SOC des équations (1) et (2), on obtient une relation entre la capacité déchargée $Q_{dch}$ et la capacité nominale $Q_{nom}$ qui est traduite par l'équation (3) :

$$Q_{dch} = \left(1 - f(U_0, T)\right) Q_{nom} \qquad (3)$$

Une approximation linéaire de la capacité déchargée $Q_{dch}$, lorsque la batterie est neuve et présente une capacité nominale $Q_{nom}$, à une température T donnée, en fonction de la valeur de tension à vide $U_0$ est proposée au travers de l'équation (4) :

$$Q_{dch} = a_{dch}(T, Q_{nom}) U_0 + b_{dch}(T, Q_{nom}) \qquad (4)$$

avec $a_{dch}$ et $b_{dch}$ étant des constantes par rapport à la tension à vide $U_0$, mais dépendant à la fois de la capacité nominale $Q_{nom}$ et de la température T.

La figure 2 représente schématiquement un exemple de courbe montrant la relation pouvant exister entre d'une part la capacité déchargée d'une batterie neuve et d'autre part la tension à vide de cette batterie. La capacité déchargée $Q_{dch}$ est exprimée en Ampères heure tandis que la tension à vide $U_0$ est exprimée en Volts. La figure 2 montre, pour une température T valant 20°C, et pour trois batteries neuves distinctes mais présentant toutes la même capacité nominale $Q_{nom}$ valant 60 Ampères heures, que l'approximation linéaire de l'équation (4) est dans l'ensemble très proche des valeurs expérimentales mesurées, et que par conséquent il est tout à fait légitime de considérer cette approximation linéaire comme valide. Les croix représentent les mesures expérimentales associées à une première batterie. Les ronds représentent les mesures expérimentales associées à une deuxième batterie. Les étoiles représentent les mesures expérimentales associées à une troisième batterie. La droite D représente l'approximation linéaire de l'équation (4).

Le principe de l'estimation 2 de la résistance interne R de la batterie, selon le procédé d'estimation de la résistance interne de la batterie selon l'invention, préférentiellement réalisée par la méthode dite d'invalidation de modèle, va maintenant être expliqué.

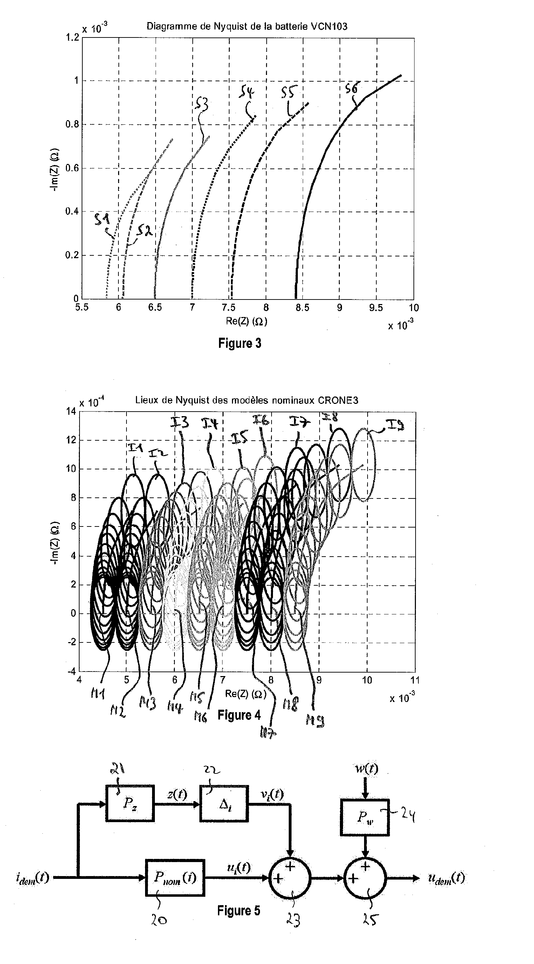

La figure 3 représente schématiquement des exemples de diagramme de Nyquist de l'impédance d'une batterie usagée pour différents états de charge de la batterie. L'opposé de la partie imaginaire de l'impédance de la batterie est représenté en ordonnée en fonction de la partie réelle de l'impédance de la batterie qui est située en abscisse. Les parties réelle comme imaginaire de l'impédance sont exprimées en ohms. Les spectres S1 à S6 représentent respectivement différents états de charge de la batterie, à savoir 100%, 90%, 80%, 70%, 60% et 50%, correspondant à différentes valeurs de résistance interne de batterie qui peuvent être lues sur l'axe des abscisses. En observant les diagrammes de Nyquist représentés sur la figure 3, on constate que ceux-ci présentent une particularité géométrique, à savoir que les courbes S1 à S6 semblent évoluer de façon homothétique en fonction de la valeur de la résistance interne de la batterie représentée en abscisse.

La figure 4 représente schématiquement des exemples de diagramme de Nyquist de différents modèles nominaux de batterie associés à leurs modèles d'incertitude respectifs. A chacune des valeurs de résistance interne de la batterie, à savoir 4.5 mΩ, 5 mΩ, 5.5 mΩ, 6 mΩ, 6.5 mΩ, 7 mΩ, 7.5 mΩ, 8 mΩ et 8.5 mΩ, correspond respectivement un modèle nominal, à savoir M1, M2, M3, M4, M5, M6, M7, M8 et M9. A chacun des modèles nominaux M1 à M9, correspond respectivement un modèle d'incertitude I1 à I9. Pour chaque couple de courant et tension mesurés, il y a un spectre Sj qui est le spectre le plus proche du spectre réel correspondant au courant et à la tension mesurés. Il y a donc un modèle Mj le plus proche pour lequel le spectre réel est suffisamment proche du modèle Mj pour ne pas sortir du modèle d'incertitude Ij correspondant. La batterie est alors considérée comme possédant une résistance interne proche de la résistance interne r(j) correspondant au modèle Mj.

En pratique, il n'est toutefois pas vraiment possible de mesurer le spectre réel et de le comparer à des modèles de spectre avec une bonne fiabilité. C'est pourquoi, en pratique, il est procédé de manière différente. La tactique utilisée pour estimer la résistance interne de la batterie repose sur une méthode d'invalidation de modèle expliquée de manière simplifiée à la figure 5.

La figure 5 représente schématiquement sous forme simplifiée un exemple d'action d'une famille de fonctions de transformation de courant en tension d'un procédé d'estimation de la résistance interne d'une batterie selon l'invention. En entrée se trouve le courant mesuré $i_{dem}(t)$ tandis qu'en sortie se trouve la tension mesurée $u_{dem}(t)$. Les différents modèles nominaux 20 transforment le courant mesuré $i_{dem}(t)$ en des courbes de tension $u_i(t)$. Le modèle d'incertitude 21, commun à tous les modèles nominaux 20 transforme le courant mesuré $i_{dem}(t)$ en un signal $z(t)$ homogène à une tension, lui-même transformé par les pondérations d'incertitude 22 en signaux $v_i(t)$ homogènes à des tensions. Un premier additionneur 23 additionne les signaux $u_i(t)$ et $v_i(t)$ pour chaque modèle nominal 20, tandis qu'un deuxième additionneur 25 ajoute aux résultats obtenus la transformation par un modèle de bruit 24 d'un bruit $w(t)$ commun aux différents modèles nominaux. Si pour un modèle nominal 20, par exemple $P_{nom}(j)$, le signal obtenu en sortie du deuxième additionneur 25 converge vers la tension mesurée $u_{dem}(t)$, le modèle considéré $P_{nom}(j)$ est validé. Si pour un modèle nominal 20, par exemple $P_{nom}(m)$, le signal obtenu en sortie du deuxième additionneur 25 ne converge pas vers la tension mesurée $u_{dem}(t)$, le modèle considéré $P_{nom}(m)$ est invalidé. Le modèle nominal validé, ou les modèles nominaux validés s'ils sont plusieurs, correspondent à des résistances internes voisines de la résistance interne réelle de la batterie. Dans le cas d'un seul modèle nominal validé, on peut avantageusement considérer que la résistance interne correspondante est une bonne approximation de la résistance interne effective de la batterie. Dans le cas de plusieurs modèles nominaux validés, on peut sélectionner le plus proche des modèles validés ou bien effectuer une moyenne pondérée des modèles validés, la pondération étant fonction de la proximité du modèle, pour déterminer la valeur de la résistance interne qui sera considérée comme étant une bonne approximation de la résistance interne effective de la batterie.

La condition de convergence passe par l'existence de w(t) et de $\Delta_i(j\omega)$, conditionnées respectivement par les équations (5) et (6) :

$$\left\| w(t) \right\|_2 < 1 \qquad\qquad (5)$$

$$\left\| \Delta_i(j\omega) \right\|_\infty < 1 \qquad\qquad (6)$$

qui montrent que la norme euclidienne du bruit, équation (5), tout comme la norme infinie de la pondération d'incertitude, équation (6), doivent rester bornées lorsqu'elles essayent de faire converger la sortie du deuxième additionneur 25 vers la tension mesurée $u_{dem}(t)$.

L'estimation 2 de la résistance interne R de la batterie, selon le procédé d'estimation de la résistance interne de la batterie selon l'invention, préférentiellement réalisée par la méthode dite d'invalidation de modèle, va maintenant être détaillée.

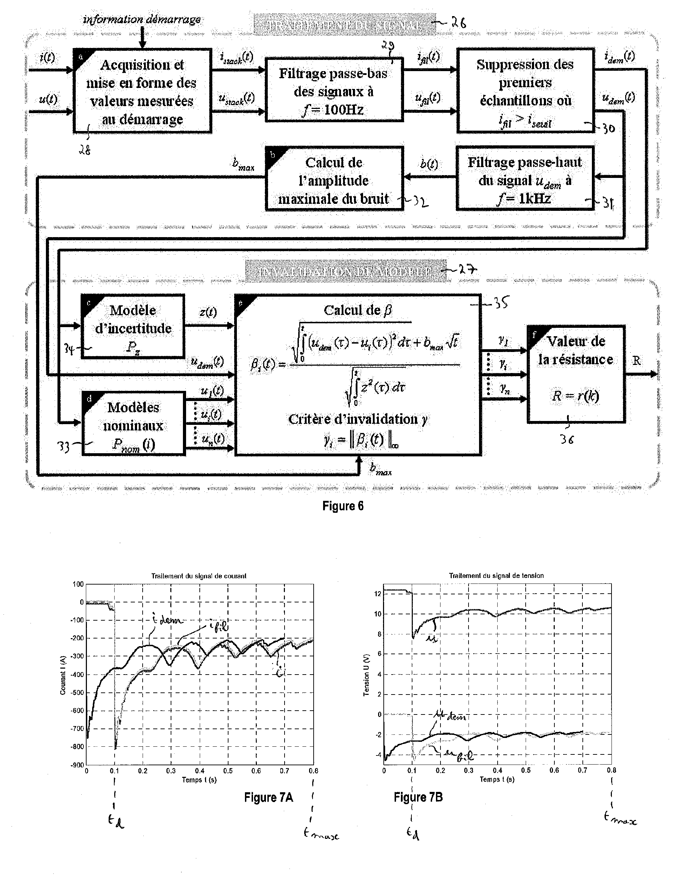

La figure 6 représente schématiquement un diagramme montrant les différentes étapes d'un exemple de procédé d'estimation de la résistance interne de batterie selon l'invention. Les différentes étapes sont réparties en deux parties principales, la partie traitement du signal 26 et la partie invalidation de modèle 27 proprement dite.

Au cours du temps s'écoulant depuis l'information de démarrage correspondant au temps t = 0 jusqu'à un instant $t_{max}$ correspondant à un courant redevenu positif, c'est-à-dire lorsque l'alternateur charge la batterie, d'une part le courant i traversant la batterie et d'autre part la tension u aux bornes de la batterie sont mesurés.

Dans une première étape 28 d'acquisition et de mise en forme des valeurs de courant i et de tension u brut mesurées au démarrage, plusieurs opérations sont successivement effectuées. Tout d'abord une opération de détection du temps td marquant le début effectif du démarrage du véhicule automobile correspondant à une chute de courant au dessous d'un seuil de courant $i_{seuil}$. Puis, une opération d'intégration depuis l'origine jusqu'à l'instant $t_d$, du courant i et de la tension u, de manière à obtenir respectivement le courant d'offset $I_{offset}$ et la tension d'offset $U_{offset}$, par l'intermédiaire des équations (7) :

$$\forall t \in [0;t_d] \quad \begin{cases} U_{offset} = \dfrac{1}{t_d}\displaystyle\int_0^{t_d} u(t)dt \\[3mm] I_{offset} = \dfrac{1}{t_d}\displaystyle\int_0^{t_d} i(t)dt \end{cases} \qquad (7)$$

Ensuite, une opération de recalage de l'amplitude des signaux de courant i et de tension u est réalisée de manière à retirer du courant i et de la tension u respectivement le courant d'offset $I_{offset}$ et la tension d'offset $U_{offset}$, par l'intermédiaire des équations (8), afin d'obtenir un courant $i_{stack}$ et une tension $u_{stack}$ :

$$\forall t \in [0;t_{max}] \quad \begin{cases} u_{stack}(t) = u(t) - U_{offset} \\[2mm] i_{stack}(t) = i(t) - I_{offset} \end{cases} \qquad (8)$$

Dans une autre étape 29 de filtrage passe-bas des signaux en dessous d'une fréquence de 100 Hz, les signaux de courant $i_{stack}$ et de tension $u_{stack}$ sont filtrées de manière à obtenir les signaux de courant $i_{fi1}$ et de tension $u_{fi1}$.

A partir de ces signaux de courant $i_{fi1}$ et de tension $u_{fi1}$, une étape 30 de suppression des premiers échantillons pour lesquels $i_{fi1}$ est supérieur à $i_{seuil}$ est réalisée. Cette étape 30 revient à effectuer un recalage temporel dans lequel l'ancien instant $t_d$ de démarrage effectif devient la nouvelle origine des temps. Les signaux de courant $i_{dem}$ et de tension $u_{dem}$ obtenus sont les courant de démarrage $i_{dem}$ et tension de démarrage $u_{dem}$. Ce recalage temporel est effectué par l'intermédiaire des équations (9) :

$$\forall t \in [t_d; t_{max}] \qquad \begin{cases} u_{dem}(t - t_d) = u_{fil}(t) \\ i_{dem}(t - t_d) = i_{fil}(t) \end{cases} \qquad (9)$$

La figure 7A représente schématiquement un exemple de l'évolution, en fonction du temps, du courant traversant la batterie d'un véhicule automobile, lors du démarrage du véhicule automobile. Le courant exprimé en ampères et situé en ordonnée est représenté en fonction du temps exprimé en secondes et situé en abscisse. On voit le courant brut mesuré i, le courant filtré $i_{fil}$, le courant de démarrage $i_{dem}$.

La figure 7B représente schématiquement un exemple de l'évolution, en fonction du temps, de la tension aux bornes de la batterie d'un véhicule automobile, lors du démarrage du véhicule automobile. La tension exprimée en volts et située en ordonnée est représentée en fonction du temps exprimé en secondes et situé en abscisse. On voit la tension brut mesurée u, la tension filtrée $u_{fil}$, la tension de démarrage $u_{dem}$.

Dans une étape 31 de filtrage passe haut de la tension de démarrage $u_{dem}$ au dessus d'une fréquence de 1 kHz, est obtenu le bruit b(t). Dans une étape 32 de calcul de l'amplitude maximale du bruit, cette amplitude maximale $b_{max}$ est déterminée, par l'intermédiaire de l'équation (10) :

$$\forall t \in [0; t_{max} - t_d] \qquad b_{max} = \max\left( b(t) - \frac{1}{t_{max} - t_d} \int_0^{t_{max} - t_d} b(t) dt \right) \qquad (10)$$

Dans une étape 33, le courant de démarrage est injecté en entrée des modèles nominaux $P_{nom}(i)$ pour donner les tensions ui et dans une étape 34, le courant de démarrage est injecté en entrée du modèle d'incertitude $P_z$ pour donner le signal z(t).

Dans une étape 35, une tactique différente de la tactique représentée à la figure 5 va être mise en oeuvre. En effet, la tactique présentée à la figure 5 présente un inconvénient notable, à savoir la double optimisation concernant d'une part la pondération d'incertitude et d'autre part le bruit. Cette double optimisation va requérir la résolution de problèmes d'optimisation convexe pouvant s'exprimer sous la forme de contraintes de type inégalités matricielles linéaires. C'est une solution relativement gourmande en capacités de calcul. Une approche simplifiée considérant que le bruit est un bruit blanc d'amplitude $b_{max}$ et de valeur moyenne nulle lui est donc préférée. Ainsi, pour chacune des courbes de tension $u_i$ obtenue après l'étape 33, on obtient une équation (11) donnant la tension de démarrage $u_{dem}$ :

$$u_{dem}(t) = u_i(t) + v_i(t) + w(t) \qquad (11)$$

Puis, on peut obtenir l'expression de la perturbation $v_i$ associée à chacun des modèles nominaux, par l'intermédiaire d'une équation (12) :

$$v_i(t) = u_{dem}(t) - u_i(t) - w(t) \qquad (12)$$

Puis, on obtient l'expression de l'énergie de chacune des perturbations $v_i$ par l'intermédiaire d'une équation (13) qui ne se confond pas avec le calcul d'une valeur efficace, car le signal considéré n'est pas périodique :

$$\sqrt{\int_0^{t_{\max}-t_d} v_i^2(t)\,dt} = \sqrt{\int_0^{t_{\max}-t_d} \left(u_{dem}(t)-u_i(t)-w(t)\right)^2 dt} \qquad (13)$$

Puis, on va majorer l'énergie de cette perturbation vi laquelle ne peut pas être précisément calculée puisque l'expression précise du bruit w est inconnue. La majoration est obtenue à l'aide de l'inégalité de Minkowski qui donne par l'intermédiaire de l'équation (14) :

$$\sqrt{\int_0^{t_{\max}-t_d} v_i^2(t)\,dt} \le \sqrt{\int_0^{t_{\max}-t_d} \left(u_{dem}(t)-u_i(t)\right)^2 dt} + \sqrt{\int_0^{t_{\max}-t_d} w^2(t)\,dt} \qquad (14)$$

Puis, l'amplitude maximale du bruit w valant $b_{max}$, il est possible de déterminer un majorant $\beta_i$ de la pondération d'incertitude $\Delta_i$, par l'intermédiaire de l'équation (15) :

$$\left\|\Delta_i(t)\right\|_2 = \frac{\left\|v_i(t)\right\|_2}{\left\|z(t)\right\|_2} \le \beta_i(t) = \frac{\sqrt{\int_0^t \left(u_{dem}(\tau)-u_i(\tau)\right)^2 d\tau} + b_{\max}\sqrt{t}}{\sqrt{\int_0^t z^2(\tau)\,d\tau}} \qquad (15)$$

Enfin, le critère d'invalidation $\gamma_i$ final retenu pour chacun des modèles nominaux est choisi comme la norme infinie du majorant $\beta_i$, c'est-à-dire comme le maximum de la valeur absolue du majorant $\beta_i$. Il est obtenu par l'intermédiaire de l'équation (16) :

$$\gamma_i = \left\|\beta_i(t)\right\|_\infty \qquad (16)$$

Dans une étape 36 de choix de la valeur de la résistance interne de la batterie, après avoir calculé ou tenté de calculer tous les $\gamma_i$, on regarde quel est ou quels sont les $\gamma_i$ dont la valeur reste inférieure à 1. Seuls les $\gamma_i$ dont la valeur est inférieure à 1 sont sélectionnés et les modèles nominaux $P_{nom}(i)$ sont considérés comme non invalidés, les modèles nominaux $P_{nom}(j)$ dont les $\gamma_j$ sont supérieurs à 1 sont considérés au contraire comme des modèles invalidés. Les $\gamma_i$ dont la valeur reste inférieure à 1 sélectionnés sont au nombre N. Il y a donc un nombre N de modèles nominaux non invalidés. Différentes situations peuvent se présenter selon la valeur du nombre N. Les $\gamma_i$ sont numérotés arbitrairement de $\gamma_1$ à $\gamma_n$, et correspondent respectivement à des valeurs de résistance interne de batterie r(i) allant de r(1) à r(n), les valeurs r(i) étant classées dans un ordre croissant de r(1), plus petite valeur de résistance interne considérée, en dessous de laquelle la batterie présente un court-circuit, à r(n), plus grande valeur de résistance interne considérée, au-delà de laquelle la batterie est soit trop déchargée soit trop usagée.

Dans une première situation où N = 0, il n'y a aucun modèle nominal non invalidé. Deux cas de figure peuvent se présenter selon les valeurs relatives de $\gamma_1$ et de $\gamma_n$. Dans un premier cas de figure où $\gamma_1$ est inférieur à $\gamma_n$, la valeur R de la résistance interne de la batterie est inférieure à r(1), et par conséquent la batterie présente un court-circuit. Dans un deuxième cas de figure où $\gamma_1$ est supérieur à $\gamma_n$, la valeur R de la résistance interne de la batterie est supérieure à r(n), et par conséquent la batterie est soit déchargée soit usagée ou vieillie.

Dans une deuxième situation où N = 1, il n'y a qu'un seul modèle nominal non invalidé. Soit $\gamma_k$ le seul critère d'invalidation inférieur à 1. La valeur R de la résistance interne de la batterie est considérée comme étant très proche de r(k), et la valeur R de la résistance interne de la batterie est choisie comme égale à r(k).

Dans une troisième situation où N > 1, il y a plusieurs modèles nominaux non invalidés. Soit $\gamma_j$ les critères d'invalidation qui sont inférieurs à 1. Deux méthodes de choix de la valeur de la résistance interne de la batterie peuvent par exemple être utilisées. Selon une première méthode préférentielle, le modèle nominal correspondant au plus petit des critères d'invalidation, à savoir $y_k$, est considéré comme le seul modèle nominal représentatif de la valeur effective de la résistance interne de la batterie. Ainsi la valeur R de la résistance interne de la batterie est considérée comme étant très proche de r(k), et la valeur R de la résistance interne de la batterie est choisie comme égale à r(k). Selon une deuxième méthode optionnelle alternative, les modèles nominaux correspondant à tous les critères d'invalidation $\gamma_j$ inférieurs à 1 sont considérés comme partiellement représentatifs de la valeur effective de la résistance interne de la batterie, à concurrence de la pertinence de leur valeur, une valeur plus faible de critère d'invalidation étant plus pertinente qu'une valeur plus forte de critère d'invalidation. La pondération est choisie comme proportionnelle à l'inverse de la valeur du critère d'invalidation considéré. Ainsi la valeur R de la résistance interne de la batterie est considérée comme étant très proche des r(j), et la valeur R de la résistance interne de la batterie est choisie comme égale à la moyenne des r(j) pondérée par l'inverse des valeurs des critères d'invalidation $\gamma_j$ correspondants.

Les formules mathématiques donnant le choix de la valeur de la résistance interne de la batterie dans les trois situations précédentes sont regroupées dans le tableau des méthodes de choix de la valeur de la résistance interne de la batterie en fonction du nombre des modèles non invalidés.

Tableau des méthodes de choix de la valeur de la résistance interne de la batterie en fonction du nombre de modèles non invalidés

| Nombre de modèles non invalidés $N$ | Méthodes d'estimation de la résistance batterie |
|---|---|
| $N = 0$ <br> $\gamma_1 < \gamma_n$ | Batterie en court-circuit : $R < r(1)$ |
| $N = 0$ <br> $\gamma_1 > \gamma_n$ | Batterie déchargée ou vieillie : $R > r(n)$ |
| $N = 1$ | $\exists! k \in [1;n] / \gamma_k \leq 1 \implies R = r(k)$ |
| $N > 1$ <br> ($1^{\text{ère}}$ méthode) | Minimisation du critère $\gamma$ : <br> $\exists! k \in [1;n] / \gamma_k = \min_i \gamma_i \implies R = r(k)$ |
| $N > 1$ <br> ($2^{\text{ème}}$ méthode) | Moyenne pondérée : <br> $\forall j = \{ i \mid \gamma_i \leq 1 \} \quad R = \left( \sum_j \frac{r(j)}{\gamma_j} \right) \left( \sum_j \frac{1}{\gamma_j} \right)^{-1}$ |

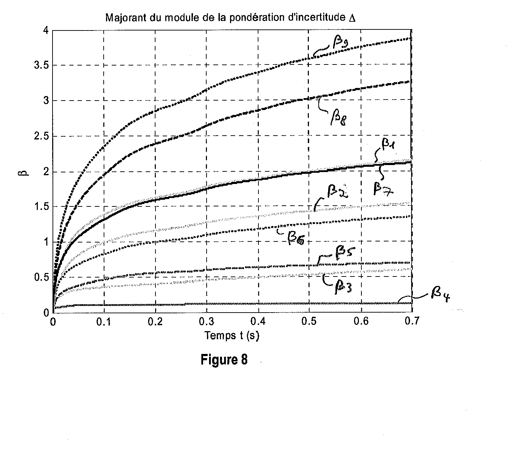

La figure 8 représente schématiquement un exemple d'évolutions, en fonction du temps, pour une famille de fonctions de transformation de courant en tension, du majorant du module de la pondération d'incertitude utilisé dans un procédé d'estimation de la résistance interne de la batterie selon l'invention. Les valeurs des critères d'invalidation correspondent aux maximas des courbes représentées sur la figure 8.

La courbe $\beta_1$ correspond à une valeur de résistance interne r(1) de 4.5 mΩ et son critère d'invalidation $\gamma_1$ vaut 2.1487. La courbe $\beta_2$ correspond à une valeur de résistance interne r(2) de 5 mΩ et son critère d'invalidation $\gamma_2$ vaut 1.5385. La courbe $\beta_3$ correspond à une valeur de résistance interne r(3) de 5.5 mΩ et son critère d'invalidation $\gamma_3$ vaut 0.60163. La courbe $\beta_4$ correspond à une valeur de résistance interne r(4) de 6 mΩ et son critère d'invalidation $\gamma_4$ vaut 0.1271. La courbe $\beta_5$ correspond à une valeur de résistance interne r(5) de 6.5 mΩ et son critère d'invalidation $\gamma_5$ vaut 0.69696. La courbe $\beta_6$ correspond à une valeur de résistance interne r(6) de 7 mΩ et son critère d'invalidation $\gamma_6$ vaut 1.3475. La courbe $\beta_7$ correspond à une valeur de résistance interne r(7) de 7.5 mΩ et son critère d'invalidation $\gamma_7$ vaut 2.1091. La courbe $\beta_8$ correspond à une valeur de résistance interne r(8) de 8 mΩ et son critère d'invalidation $\gamma_8$ vaut 3.2574. La courbe $\beta_9$ correspond à une valeur de résistance interne r(9) de 8.5 mΩ et son critère d'invalidation $\gamma_9$ vaut 3.8662.

Selon la première méthode de choix préférentielle, le plus petit critère d'invalidation est $\gamma_4$ et vaut 0.1271. La résistance interne r(4) associée vaut 6 mΩ. La valeur R de la résistance interne de la batterie vaut donc 6 mΩ. Selon la deuxième méthode de choix optionnelle, les critères d'invalidation inférieurs à 1 sont $\gamma_3$, $\gamma_4$ et $\gamma_5$. La moyenne pondérée des résistances internes r(3), r(4) et r(5), valant respectivement 5.5 mΩ, 6 mΩ et 6.5 mΩ vaut 5.99 mΩ, soit une valeur extrêmement proche de la précédente à mieux que 1% près.

L'estimation de la tension minimale $U_{min}$ lors du prochain pic de démarrage, selon le procédé d'estimation de la performance en puissance d'une batterie de véhicule automobile lors du démarrage du véhicule automobile selon l'invention, va maintenant être détaillée.

La relation entre la force électromotrice E de la batterie, la tension minimale $U_{min}$ lors du prochain pic de démarrage et le courant minimal $I_{min}$ correspondant, est donnée par la loi d'ohm, par l'intermédiaire de l'équation (17), la force électromotrice E dépendant non seulement de la tension à vide $U_0$, mais aussi de la capacité chargée $Q_{cha}$ qui varie au cours du temps :

$$U_{min} = E\left(U_0, Q_{cha}(t)\right) + RI_{min} \qquad (17)$$

En reprenant et en inversant l'équation (4), on peut exprimer la tension à vide $U_0$ en fonction de la capacité déchargée $Q_{dch}$, ce qui donne l'équation (18) :

$$U_0 = \frac{1}{a_{dch}(T, Q_{nom})} Q_{dch} - \frac{b_{dch}(T, Q_{nom})}{a_{dch}(T, Q_{nom})} \qquad (18)$$

Si l'on dérive la tension à vide $U_0$ par rapport à la capacité déchargée $Q_{dch}$, on obtient l'équation (19) :

$$\frac{dU_0}{dQ_{dch}} = \frac{1}{a_{dch}(T, Q_{nom})} \qquad (19)$$

La variation $\Delta Q_{dch}$ de la capacité déchargée $Q_{dch}$ peut s'exprimer à tout instant t, comme la différence de capacité disponible entre d'une part l'instant référence auquel la tension aux bornes de la batterie vaut la tension à vide $U_0$, et d'autre part l'instant t considéré, ce qui donne l'équation (20) :

$$\Delta Q_{dch}(t) = -Q_{cha}(t) \qquad (20)$$

A partir des équations (19) et (20), on peut en déduire l'expression de la force électromotrice de la batterie, en fonction du temps, ce qui donne l'équation (21) :

$$E(t) = U_0 + \Delta U_0(t) = U_0 - \frac{Q_{cha}(t)}{a_{dch}(T, Q_{nom})} \qquad (21)$$

Puis, en injectant l'équation (21) dans l'équation (17), on obtient l'expression de la tension minimale $U_{min}$.

Un calcul 4 de la capacité chargée $Q_{cha}$ et de la capacité disponible $Q_{disp}$ va maintenant être détaillé. La capacité chargée $Q_{cha}$ s'obtient par intégration du courant au cours du temps. On obtient ainsi l'équation (22) :

$$Q_{cha}(t) = \int_0^t i(\tau) d\tau \qquad (22)$$

La capacité disponible $Q_{disp}$ peut être considérée comme une somme algébrique de la capacité nominale $Q_{nom}$, de la capacité déchargée $Q_{dch}$ et de la capacité chargée $Q_{cha}$, ce qui donne l'équation (23) :

$$Q_{disp}(t) = Q_{nom} - Q_{dch} + Q_{cha}(t) \qquad (23)$$

Un calcul 5 de la capacité $Q_{max}$ maximale disponible à l'état chargé de la batterie va maintenant être détaillé.

La capacité maximale $Q_{max}$ est la capacité disponible lorsque la batterie est chargée à 100%, c'est-à-dire complètement chargée. Cette capacité maximale est calculée en fin de charge, c'est-à-dire lorsque la tension aux bornes de la batterie est devenue supérieure à une tension seuil $u_{seuil}$ et lorsque le courant traversant la batterie est devenu inférieur à un courant seuil $i_{min}$. Un coefficient $\alpha$ d'efficacité de charge, supérieur à 1, est introduit dans l'équation (24), pour tenir compte, en fin de charge de la batterie, de la consommation de courant due à la réaction parasite d'électrolyse de l'eau contenue dans l'électrolyte de la batterie :

$$Q_{max}(t) = Q_{nom} - Q_{dch} + \alpha\, Q_{cha}(t) \qquad (24)$$

Le coefficient $\alpha$ vaut par exemple 1.05. La relative simplicité de l'ensemble des calculs effectués, obtenue à l'aide des approximations judicieuses précitées, permet avantageusement d'héberger le logiciel mettant en oeuvre tout ou partie des procédés décrits précédemment dans un calculateur déjà existant dans le véhicule automobile. Ainsi, de manière avantageuse, il n'est pas nécessaire, même si cela reste possible, d'ajouter dans le véhicule automobile un calculateur dédié pour mettre en oeuvre l'invention, au moins dans sa forme préférentielle.

**Revendications**

1. Procédé d'estimation de la résistance interne d'une batterie de véhicule automobile, comprenant :

   - une mesure du courant (i) traversant la batterie en fonction du temps (t) lors du démarrage du véhicule automobile ;
   - une mesure de la tension (u) aux bornes de la batterie en fonction du temps (t) lors du démarrage du véhicule automobile ;
   - une étape d'injection (33) du courant mesuré ($i_{dem}$) en fonction du temps en entrée d'une famille de fonctions de transformation ($T_i$) de courant en tension, les fonctions de transformation correspondant respectivement à des valeurs ($r(i)$) distinctes entre elles de la résistance interne de la batterie, le résultat de cette étape injection étant une famille de courbes de tension ($u_i$) en fonction du temps qui sont représentatives de la tension en fonction du temps aux bornes de la batterie qui serait obtenue lors du démarrage du véhicule pour lesdites valeurs de résistance interne de la batterie ;
   - une étape de comparaison (35) entre d'une part la tension mesurée ($u_{dem}$) en fonction du temps et d'autre part la famille de courbes de tension ($u_i$) en fonction du temps, de manière à déterminer une ou plusieurs courbes de tension cible qui sont la ou les courbes de tension de la famille les plus proches de la tension mesurée ;
- une étape de choix (36), comme valeur (R) de la résistance interne de la batterie, de la valeur (r(k)) de résistance interne correspondant à la fonction de transformation ayant donné la courbe de tension cible ou d'une fonction de moyenne des valeurs de résistance interne correspondant aux fonctions de transformation ayant donné les courbes de tension cible.

2. Procédé d'estimation de la résistance interne d'une batterie selon la revendication 1, **caractérisé en ce que** l'étape de comparaison (35) entre d'une part la tension mesurée en fonction du temps et d'autre part la famille de courbes de tension en fonction du temps, détermine une courbe de tension cible qui est la courbe de tension de la famille la plus proche de la tension mesurée, et **en ce que** l'étape de choix (36) prend, comme valeur de la résistance interne de la batterie, la valeur de la résistance interne correspondant à la fonction de transformation ayant donné la courbe de tension cible.

3. Procédé d'estimation de la résistance interne d'une batterie selon l'une quelconque des revendications précédentes, **caractérisé en ce que** la fonction de transformation effectue successivement :

   - une première opération de transformation du courant mesuré en fonction du temps en un courant mesuré en fonction de la fréquence ;
   - une deuxième opération de transformation du courant mesuré en fonction de la fréquence en une courbe de tension en fonction de la fréquence au moyen d'un produit du courant mesuré en fonction de la fréquence par la fonction de transfert de la fonction de transformation ;
   - une troisième opération de transformation de la courbe de tension en fonction de la fréquence en une courbe de tension en fonction du temps.

4. Procédé d'estimation de la résistance interne d'une batterie selon la revendication 3, **caractérisé en ce que**, pour chacune des fonctions de transformation $T_i$ de la famille, la deuxième opération est réalisée à l'aide d'une fonction $F_i$ ayant la forme suivante : $F_i = K_{1i} (G_i (f))^{x_i}$ ; avec $K_{1i}$ constante, $G_i$ une autre fonction, f la fréquence, $x_i$ un nombre réel ou complexe, $x_i$ étant un nombre non entier pour au moins une fonction de transformation.

5. Procédé d'estimation de la résistance interne d'une batterie selon la revendication 4, **caractérisé en ce que**, pour chacune des fonctions de transformation $T_i$ de la famille, la deuxième opération est réalisée à l'aide d'une fonction $F_i$ ayant la forme suivante : $F_i = K_{1i} (G_i (f))^{x_i}$ ; avec $K_{1i}$ constante, $G_i$ une autre fonction, f la fréquence, $x_i$ un nombre réel ou complexe, $x_i$ étant un nombre non entier pour plusieurs fonctions de transformation.

6. Procédé d'estimation de la résistance interne d'une batterie selon la revendication 5, **caractérisé en ce que**, pour chacune des fonctions de transformation $T_i$ de la famille, la deuxième opération est réalisée à l'aide d'une fonction $F_i$ ayant la forme suivante : $F_i = K_{1i} (G_i (f))^{x_i}$ ; avec $K_{1i}$ constante, $G_i$ une autre fonction, f la fréquence, $x_i$ un nombre réel ou complexe, $x_i$ étant un nombre non entier pour toutes les fonctions de transformation.

7. Procédé d'estimation de la résistance interne d'une batterie selon l'une quelconque des revendications 4 à 6, **caractérisé en ce que**, pour chacune des fonctions de transformation $T_i$ de la famille, la fonction $G_i$ a la forme suivante : $G_i = (K_{2i} + jw) / (K_{3i} + jw)$ ; avec $K_{2i}$ et $K_{3i}$ constantes, $w = 2 \pi f$, j le nombre complexe tel que $j^2 = -1$.

8. Procédé d'estimation de la résistance interne d'une batterie selon l'une quelconque des revendications précédentes, **caractérisé en ce que** la fonction de transformation effectue une unique opération de transformation du courant mesuré en fonction du temps en une courbe de tension en fonction du temps au moyen d'un produit de convolution du courant mesuré en fonction du temps par la réponse impulsionnelle de la fonction de transformation.

9. Procédé d'estimation de la résistance interne d'une batterie selon l'une quelconque des revendications précédentes, **caractérisé en ce que** l'étape de comparaison effectue successivement :

   - pour une ou plusieurs courbes de tension, une première opération de calcul d'une grandeur représentative de l'énergie en fonction du temps de la différence entre la tension mesurée et la courbe de tension ;
   - sur une plage temporelle donnée, une opération de ratio entre d'une part la grandeur représentative de l'énergie en fonction du temps et d'autre part un seuil variable en fonction du temps ;
   - soit une opération de validation de la courbe de tension si le majorant des ratios sur la plage temporelle donnée ne dépasse pas un seuil prédéterminé et identique pour toutes les courbes de tension, soit une opération d'invalidation de la courbe de tension si le majorant des ratios sur la plage temporelle donnée dépasse ledit seuil prédéterminé.

**10.** Procédé d'estimation de la résistance interne d'une batterie selon la revendication 2 et la revendication 9, **caractérisé en ce que :**

- si une seule courbe de tension a été validée, la courbe de tension cible est ladite courbe de tension validée ;
- si plusieurs courbes de tension ont été validées, la courbe de tension cible est la courbe de tension validée présentant le plus petit majorant ($\gamma_k$) ;
- si aucune courbe de tension n'est validée, soit le majorant ($\gamma_1$) de la courbe de tension correspondant à la plus petite valeur de résistance interne de la batterie est inférieur au majorant ($\gamma_n$) de la courbe de tension correspondant à la plus grande valeur de résistance interne de la batterie et une information de court-circuit de la batterie est émise sur le réseau du véhicule automobile, soit le majorant ($\gamma_1$) de la courbe de tension correspondant à la plus petite valeur de résistance interne de la batterie est supérieur au majorant ($\gamma_n$) de la courbe de tension correspondant à la plus grande valeur de résistance interne de la batterie et une information de décharge excessive ou de vieillissement excessif de la batterie est émise sur le réseau du véhicule automobile.

**11.** Procédé d'estimation de la résistance interne d'une batterie selon la revendication 9, **caractérisé en ce que :**

- si une seule courbe de tension a été validée, la courbe de tension cible est ladite courbe de tension validée ;
- si plusieurs courbes de tension ont été validées, les courbes de tension cibles sont les courbes de tension validées, la valeur (R) de la résistance interne de la batterie étant obtenue à l'aide de la moyenne arithmétique des valeurs de résistance interne correspondant aux fonctions de transformation ayant donné les courbes de tension cibles respectivement pondérées par les valeurs des majorants ($\gamma_j$) correspondant aux dites courbes de tension cibles ;
- si aucune courbe de tension n'est validée, soit le majorant ($\gamma_1$) de la courbe de tension correspondant à la plus petite valeur de résistance interne de la batterie est inférieur au majorant ($\gamma_n$) de la courbe de tension correspondant à la plus grande valeur de résistance interne de la batterie et une information de court-circuit de la batterie est émise sur le réseau du véhicule automobile, soit le majorant ($\gamma_1$) de la courbe de tension correspondant à la plus petite valeur de résistance interne de la batterie est supérieur au majorant ($\gamma_n$) de la courbe de tension correspondant à la plus grande valeur de résistance interne de la batterie et une information de décharge excessive ou de vieillissement excessif de la batterie est émise sur le réseau du véhicule automobile.

**12.** Procédé d'estimation de la résistance interne d'une batterie selon l'une quelconque des revendications 9 à 11, **caractérisé en ce que** la grandeur représentative de l'énergie en fonction du temps est un majorant de l'énergie en fonction du temps.

**13.** Procédé d'estimation de la résistance interne d'une batterie selon l'une quelconque des revendications 9 à 12, **caractérisé en ce que** le seuil prédéterminé et identique pour toutes les courbes de tension est une grandeur représentative de l'énergie d'une fonction d'incertitude en fonction du temps.

**14.** Procédé d'estimation de la résistance interne d'une batterie selon l'une quelconque des revendications précédentes, **caractérisé en ce que** les valeurs (r(i)) de résistance interne de batterie correspondant aux fonctions de transformation sont toutes inférieures à une valeur maximum de résistance interne de batterie au-delà de laquelle le démarrage du véhicule n'est plus certain.

**15.** Procédé d'estimation de la résistance interne d'une batterie selon l'une quelconque des revendications précédentes, **caractérisé en ce que** les valeurs (r(i)) de résistance interne de batterie correspondant aux fonctions de transformation sont toutes supérieures à une valeur minimum de résistance interne de batterie en dessous de laquelle le démarrage du véhicule n'est plus possible.

**16.** Procédé d'estimation de la résistance interne d'une batterie selon l'une quelconque des revendications précédentes, **caractérisé en ce que** les valeurs (r(i)) de résistance interne de batterie correspondant aux fonctions de transformation sont comprises entre 4 milli ohms et 9 milli ohms.

**17.** Procédé d'estimation de la résistance interne de batterie selon l'une quelconque des revendications précédentes, **caractérisé en ce que** les différentes fonctions de transformation correspondent respectivement à différents spectres de l'impédance de la batterie obtenus respectivement pour différents états de charge et différents états de santé de batterie.

**18.** Procédé d'estimation de la résistance interne de batterie selon l'une quelconque des revendications précédentes, **caractérisé en ce que** les différentes fonctions de transformation sont obtenues de manière empirique par séries de mesure sur plusieurs batteries de même modèle.

**19.** Procédé d'estimation de la résistance interne de batterie selon l'une quelconque des revendications précédentes, **caractérisé en ce que** les seuls paramètres mesurés sont d'une part le courant (i) traversant la batterie et d'autre part la tension (u) aux bornes de la batterie.

**20.** Procédé d'estimation de la performance en puissance d'une batterie de véhicule automobile lors du démarrage du véhicule automobile comprenant successivement :

- un procédé d'estimation de la résistance interne (R) de batterie selon l'une quelconque des revendications précédentes ;
- une phase d'estimation de la plus petite valeur de tension ($U_{min}$) lors du prochain démarrage de véhicule automobile à partir de ladite résistance interne estimée ;
- si aucune résistance interne n'a pu être déterminée par le procédé d'estimation de la résistance interne, alors une information soit de court-circuit de la batterie soit de décharge excessive ou de vieillissement excessif de la batterie est émise sur le réseau du véhicule automobile ;
- si une résistance interne a pu être déterminée par le procédé d'estimation de la résistance interne et si ladite plus petite valeur de tension estimée est inférieure à un seuil donné, alors une information de décharge excessive ou de vieillissement excessif de la batterie est émise sur le réseau du véhicule automobile.

**21.** Procédé d'estimation de la performance en puissance d'une batterie de véhicule automobile lors du démarrage du véhicule automobile selon la revendication 20, **caractérisé en ce que**, si une résistance interne a pu être déterminée par le procédé d'estimation de la résistance interne et si ladite plus petite valeur de tension estimée est supérieure audit seuil donné, alors la valeur de ladite plus petite valeur de tension estimée est émise sur le réseau du véhicule automobile.

**22.** Procédé d'estimation de la performance en puissance d'une batterie de véhicule automobile lors du démarrage du véhicule automobile selon l'une quelconque des revendications 20 à 21, **caractérisé en ce que** les seuls paramètres mesurés sont le courant (i) traversant la batterie, la tension (u) aux bornes de la batterie, et la température (T) au niveau de la batterie.

Figure 1

Figure 2

Figure 3

Figure 4

Figure 5

# EP 2 071 345 A1

Figure 6

Figure 7A

Figure 7B

Figure 8

Europäisches
Patentamt

European
Patent Office

Office européen
des brevets

**RAPPORT DE RECHERCHE EUROPEENNE**

Numéro de la demande

EP 08 17 1112

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2005/134282 A1 (AVERBUCH MOSHE [IL]) 23 juin 2005 (2005-06-23) * le document en entier * ----- | 1-22 | INV. G01R31/36 |
| A | EP 1 094 326 A (VB AUTOBATTERIE GMBH [DE] VB AUTOBATTERIE GMBH & CO KGAA [DE]) 25 avril 2001 (2001-04-25) * abrégé * ----- | 1-22 | |
| A | JP 56 148076 A (OLYMPUS OPTICAL CO) 17 novembre 1981 (1981-11-17) * abrégé; figures 1,2 * ----- | 1-22 | |
| A | US 6 087 808 A (PRITCHARD JEFFREY A [US]) 11 juillet 2000 (2000-07-11) * colonne 8, ligne 1 - ligne 38; figures 1,2,4 * * abrégé * ----- | 1-22 | |

DOMAINES TECHNIQUES
RECHERCHES (IPC)

G01R

Le présent rapport a été établi pour toutes les revendications

| Lieu de la recherche | Date d'achèvement de la recherche | Examinateur |
|---|---|---|
| Berlin | 5 mars 2009 | Koll, Hermann |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..............................................................................
& : membre de la même famille, document correspondant

EPO FORM 1503 03.82 (P04C02)

**EP 2 071 345 A1**

**ANNEXE AU RAPPORT DE RECHERCHE EUROPEENNE
RELATIF A LA DEMANDE DE BREVET EUROPEEN NO.**

EP 08 17 1112

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

05-03-2009

| Document brevet cité au rapport de recherche | | | Date de publication | Membre(s) de la famille de brevet(s) | | Date de publication |
|---|---|---|---|---|---|---|
| US | 2005134282 | A1 | 23-06-2005 | AUCUN | | |
| EP | 1094326 | A | 25-04-2001 | DE | 19950424 A1 | 26-04-2001 |
| | | | | ES | 2281320 T3 | 01-10-2007 |
| JP | 56148076 | A | 17-11-1981 | AUCUN | | |
| US | 6087808 | A | 11-07-2000 | AU | 762928 B2 | 10-07-2003 |
| | | | | AU | 4370300 A | 10-11-2000 |
| | | | | CA | 2370829 A1 | 02-11-2000 |
| | | | | CN | 1348544 A | 08-05-2002 |
| | | | | EP | 1183766 A2 | 06-03-2002 |
| | | | | JP | 2003508727 T | 04-03-2003 |
| | | | | WO | 0065705 A2 | 02-11-2000 |

EPO FORM P0460

Pour tout renseignement concernant cette annexe : voir Journal Officiel de l'Office européen des brevets, No.12/82